# EUROPEAN PATENT APPLICATION

(11) **EP 1 020 904 A1**
(43) Date of publication of application: **19.07.2000**
(21) Application number: 99925402.2
(22) Date of filing: 22.06.1999
(51) Int. Cl.: H01L 21/60

(54) **THERMOCOMPRESSION BONDING DEVICE AND BONDING HEAD THEREOF**

(30) Priority: 22.06.1998 JP 17424598
(71) Applicant: Sony Chemicals Corporation, Tokyo 103-8312 (JP)
(72) Inventor: NAGAOKA, Tsutomu, Sony Chemicals Corp., Kanuma-shi, Toshigi 322-8502 (JP)
(74) Representative: Körber, Wolfhart, Dr. rer.nat.
(86) International application number: JP9903301
(87) International publication number: WO9967819

(57) **Abstract**

The thermocompression-bonding head (10) of the thermocompression-bonding apparatus (1) according to the present invention has a ceramic layer (15) having a predetermined thickness on the contact part (130a) of the pressing member (130) of the head body (13). The difference between the thermal expansion coefficient of the head body (13) and the thermal expansion coefficient of the ceramic layer (15) is within the range of ± 30 % at a temperature of 400 °C or less.

## Description

### FIELD OF THE INVENTION

The present invention relates to a thermocompression-bonding head used for establishing interconnections between connecting terminals using, for example, an anisotropic conductive adhesive film or an insulating adhesive film.

### PRIOR ART

Interconnections between connecting terminals using an anisotropic conductive film (ACF) or the like have conventionally been established by inserting said anisotropic conductive film or the like between said connecting terminals to join them under heating and pressure by a pressing head heated at a predetermined temperature.

Such a thermocompression-bonding head is required to have a head contact face maintained within a flatness tolerance of 0.005 mm at a temperature on the order of 300 °C for a long period.

Fe-Ni-Co or the like alloys have conventionally been used as materials for thermocompression-bonding heads satisfying the above condition.

However, these conventional thermocompression-bonding heads disadvantageously could not satisfy the required flatness tolerance resulting in low yields of thermocompression bonded objects because their thermal expansion properties caused undulation in the head contact faces of their pressing members at thermocompression-bonding temperatures on the order of 300 °C.

Conventional thermocompression-bonding heads made of Ni-Co alloys were insufficient in the wear resistance of the head contact faces of their pressing members, and as a result, they were difficult to maintain a required flatness during a long-period of use so that the thermocompression-bonding heads had to be repolished every a few months.

Moreover, the above Ni-Co alloys were poor in cutting processability to increase the processing cost.

The present invention was made to solve these problems of the prior art with the object of improving the flatness of the head contact face of the pressing member in a thermocompression-bonding head of a thermocompression-bonding apparatus and maintaining said flatness for a long period.

Another object of the present invention is to provide a thermocompression-bonding apparatus having a readily processable thermocompression-bonding head.

### DISCLOSURE OF THE INVENTION

The present invention relates to a thermocompression-bonding head for establishing interconnections between connecting terminals using an adhesive film, which comprises a thermocompression-bonding head body made of a specific alloy and a pressing member provided with a ceramic layer on the contact part on the bonding side of said thermocompression-bonding head body.

According to the present invention, the presence of the ceramic layer having a small thermal expansion coefficient on the contact part of the pressing member of the thermocompression-bonding head body can readily satisfy a required flatness tolerance without causing undulation on the head contact face of the ceramic layer even when it is heated at a temperature on the order of 300 °C. As a result, the present invention can greatly improve the yield of thermocompression bonded objects.

According to the present invention, the head contact face of the pressing member is formed of a ceramic having good wear resistance so that the flatness of the head contact face can be maintained for a long period to eliminate any process for controlling contact of the thermocompression-bonding head or repolishing the head contact face or changing the thermocompression-bonding head.

Moreover, better processability of ceramics as compared with Ni-Co alloys can simplify working processes to lower the cost.

In this aspect, the present invention is more effective when the difference between the thermal expansion coefficient of the thermocompression-bonding head body and the thermal expansion coefficient of the ceramic layer is within the range of ± 30 % at a temperature of 400 °C or less.

Thus, the ceramic layer can be prevented from separation or deformation during thermocompression bonding because the thermal expansion coefficients of the thermocompression-bonding head body and the ceramic layer are close.

In this aspect, the present invention is more effective when the thickness of the ceramic layer is between 0.1 mm and 0.7 mm, which has the advantage of ensuring shock resistance under pressure.

Preferred ceramics include silicon nitride (Si₃N₄), for example.

Another aspect of the present invention relates to a process for preparing a thermocompression-bonding head for establishing interconnections between connecting terminals using an adhesive film, comprising the steps of melting a sintered rod of a ceramic material in an oxygen-acetylene flame and spraying the molten droplets of said ceramic material accelerated by air jet stream to form a layer of said ceramic material on the contact part of a pressing member of a thermocompression-bonding head body made of a specific alloy.

According to this aspect of the present invention, a ceramic layer can be obtained which shows a strong bonding power between ceramic particles as well as excellent properties in hygroscopicity and impregnancy.

In the present invention, the contact part of the pressing member need not be preliminarily polished, but after a ceramic layer has been formed, the surface of the ceramic layer may preferably be polished to keep the head contact face of the ceramic layer within a required flatness tolerance.

Another aspect of the present invention relates to a thermocompression-bonding apparatus having said thermocompression-bonding head wherein said thermocompression-bonding head can be pressed against objects to be bonded at a predetermined pressure.

According to this aspect of the present invention, a thermocompression-bonding apparatus can be obtained which achieves a high yield of thermocompression bonded objects with simple maintenance without requiring any process for controlling contact of the thermocompression-bonding head or repolishing the head contact face or the like.

### BRIEF DESCRIPTION OF THE DRAWINGS

FIG. 1 is a perspective view showing a thermocompression-bonding apparatus using a thermocompression-bonding head according to the present invention.
FIG. 2 (a) is a front view showing the appearance of the thermocompression-bonding head according to the present invention.
FIG. 2 (b) is a partial enlarged view showing the part encircled by chain line A in FIG. 2 (a).
FIG. 2 (c) is a side view showing the appearance of the thermocompression-bonding head according to the present invention.
FIG. 3 is a graph showing the relationship between the thermal expansion coefficients of the materials for the head body and the ceramic layer used in the present invention.

### THE MOST PREFERRED EMBODIMENT OF THE INVENTION

An embodiment of a thermocompression-bonding head according to the present invention and a thermocompression-bonding apparatus using it will now be described in detail with reference to the accompanying drawings.

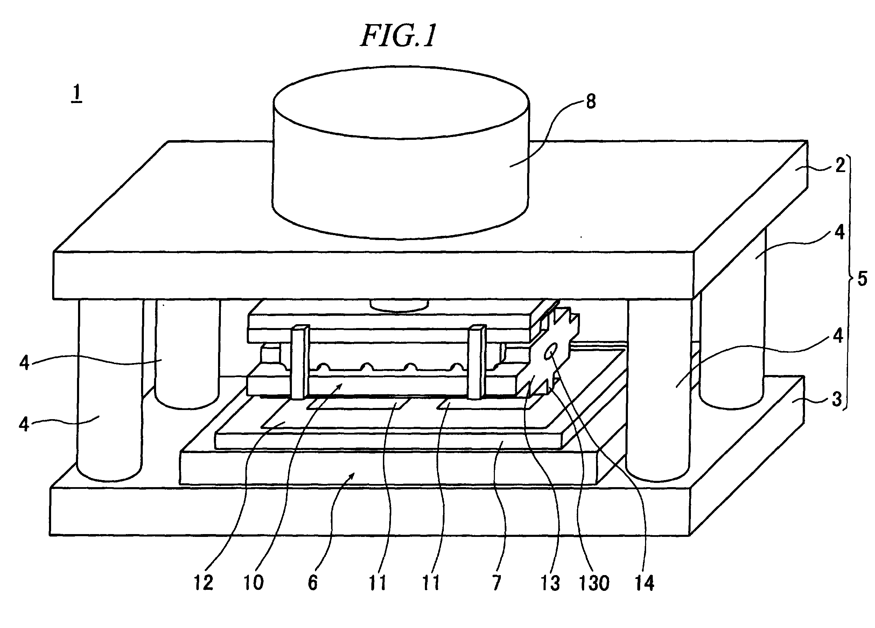

As shown in FIG. 1, a thermocompression-bonding apparatus 1 of the present invention has a body frame 5 comprising a pair of upper and lower frames in parallel 2, 3 and connecting shafts 4 for connecting said upper and lower frames 2, 3.

A single axis robotic table 6 is provided on the lower frame 3. The single axis robotic table 6 can position a table 7 made of a heat-resistant material at a predetermined position.

On the upper frame 2 is provided an air cylinder 8, which can press a thermocompression-bonding head 10 of the present invention into a vertically downward direction.

As shown in FIG. 1, a glass substrate 12 having a plurality of flexible substrates 11 provisionally compression-bonded thereto with an anisotropic conductive adhesive film or an insulating adhesive film free from conductive particles not shown is mounted on the table 7 on the single axis robotic table 6. After the table 7 on the single axis robotic table 6 is positioned, the air cylinder 8 is activated to press a pressing member 130 of a head body (thermocompression-bonding head body) 13 of the thermocompression-bonding head 10 heated at a predetermined temperature against the flexible substrates (objects to be bonded) 11 at a predetermined pressure (40 kgf/cm²).

The head body 13 is made of an alloy based on iron (Fe)-nickel (Ni)-cobalt (Co), for example, but free from sulfur (S) and having a specific thermal expansion coefficient as described below in case of the present embodiment.

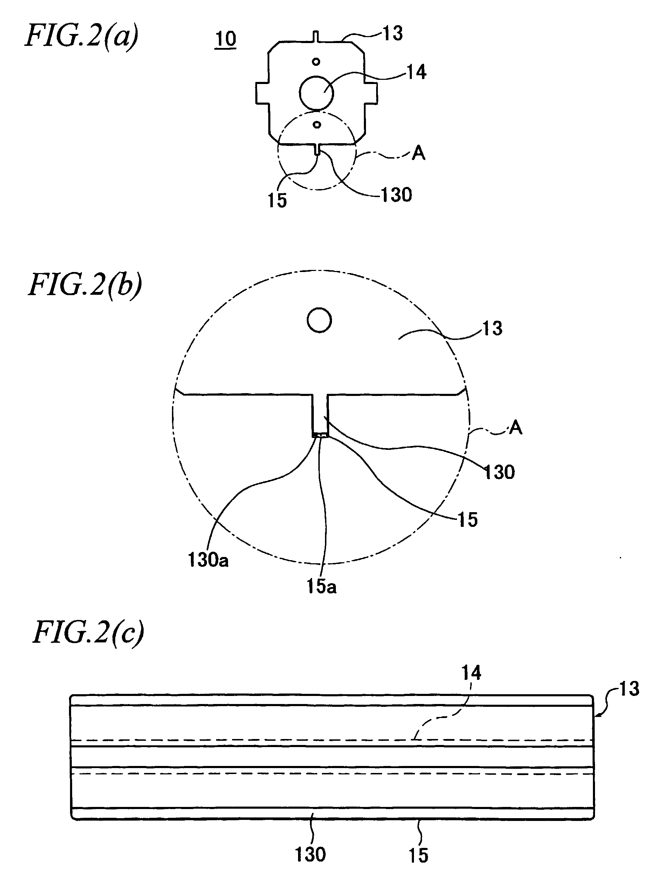

As shown in FIG. 2 (a) and (c), the thermocompression-bonding head 10 according to the present embodiment has a head body 13 in the form of a long rectangular parallelepiped, in which a heater 14 is provided in parallel with the longitudinal direction of the head body 13.

A pressing member 130 projects from the base of the head body 13 in the longitudinal direction of the head body 13. As shown in FIG. 2 (b), a ceramic layer 15 having a specific thermal expansion coefficient is provided on the contact part 130a of the pressing member 130 in case of the present embodiment.

In the present invention, the head body 13 and the ceramic layer 15 have close thermal expansion coefficients. In case of the present embodiment, for example, the difference between the thermal expansion coefficient of the head body 13 and the thermal expansion coefficient of the ceramic layer 15 is within the range of ± 30 % at a temperature of 400 °C or less.

The difference between the thermal expansion coefficients of the head body 13 and the ceramic layer 15 is more preferably within 15 % at a temperature of 400 °C or less.

If the difference between the thermal expansion coefficient of the head body 13 and the thermal expansion coefficient of the ceramic layer 15 exceeds ± 30 % at a temperature of 400 °C or less, the ceramic layer 15 may disadvantageously separate or deform.

Materials for the ceramic layer 15 satisfying said conditions in combination with said Fe-Ni-Co alloy of the head body 13 include, for example, silicon nitride (Si₃N₄).

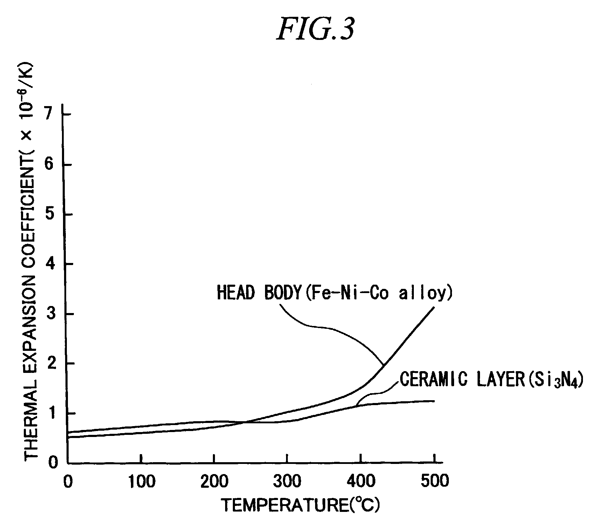

FIG. 3 shows the relationship between the thermal expansion coefficients of the materials for the head body 13 and the ceramic layer 15 used in the present embodiment.

As shown in FIG. 3, the head body (Fe-Ni-Co alloy) 13 and the ceramic layer (Si₃N₄) 15 according to the present embodiment have close thermal expansion coefficients at thermocompression-bonding temperatures of 400 °C or less, with the difference between the thermal expansion coefficient of the head body 13 and the thermal expansion coefficient of the ceramic layer 15 being within ± 30 %.

Fe-Ni-Co alloys forming such a head body 13 include, for example, LEX5 available from Nippon Chuzo Co., Ltd. or the like, while silicon nitrides forming the ceramic layer 15 include SN-220M available from Kyocera Corp. or the like.

The thickness of the ceramic layer 15 provided on the contact part 130a of the pressing member 130 of the head body 13 is not specifically limited, but preferably 0.1 mm - 0.7 mm, more preferably 0.3 mm - 0.5 mm.

If the thickness of the ceramic layer 15 is less than 0.1 mm, shock resistance cannot be ensured and crack readily occurs under pressure. If the thickness is greater than 0.7 mm, however, heat shock resistance cannot be ensured and crack readily occurs during heating because such a layer cannot follow any deformation of the substrate, i.e. head body 13.

In the present invention, the ceramic layer 15 is preferably formed by a coating technique according to, for example, the Rokide rod spray method. Namely, a sintered rod of a ceramic material to be coated is molten in an oxygen-acetylene flame at about 3000 °C and the molten droplets accelerated by air jet stream are sprayed to form a layer of said ceramic material on the contact part 130a of the pressing member 130 of the head body 13.

In this case, the contact part 130a of the pressing member 130 need not be preliminarily polished, but after a ceramic layer 15 has been formed, the surface of the ceramic layer 15 is polished with a diamond hone, for example, to form a head contact face 15a within a required flatness tolerance.

According to the present embodiment as described above, the presence of the ceramic layer 15 having a small thermal expansion coefficient on the contact part 130a of the pressing member 130 of the body of the thermocompression-bonding head 10 can readily satisfy a required flatness tolerance without causing undulation on the head contact face 15a of the ceramic layer 15 even when it is heated at a temperature on the order of 300 °C. As a result, the present embodiment can greatly improve the yield of thermocompression bonded objects.

In the practice of the present embodiment, the head contact face 15a is formed of a ceramic having good wear resistance so that the flatness of the head contact face 15a can be maintained for a long period to eliminate any process for controlling contact of the thermocompression-bonding head 10 or repolishing the head contact face 15a or changing the thermocompression-bonding head 10 and thus to lower the running cost.

Moreover, better processability of ceramics as compared with Ni-Co alloys can simplify working processes to lower the cost.

In case of the present embodiment, the ceramic layer 15 can be prevented from separation or deformation during thermocompression bonding because the thermal expansion coefficients of the head body 13 and the ceramic layer 15 are close.

In the present embodiment, the ceramic layer 15 formed by coating according to the Rokide rod spray method shows a strong bonding power between ceramic particles as well as excellent properties in hygroscopicity and impregnancy.

Thus, the present embodiment can provide a thermocompression-bonding apparatus, which achieves a high yield of thermocompression bonded objects with simple maintenance.

The present invention is not limited to the above embodiment, but various modifications can be made.

For example, various materials can be used for the thermocompression-bonding head body and the ceramic layer without departing from the spirit of the present invention.

The head body and the pressing member of the thermocompression-bonding head are not limited to those of the above embodiment, but may be appropriately changed depending on the thermocompression-bonding conditions.

### INDUSTRIAL APPLICABILITIES

As has been described above, the present invention can readily satisfy a required flatness tolerance for the head contact face and greatly improve the yield of thermocompression bonded objects.

The present invention can also maintain the flatness of the head contact face for a long period to eliminate any process for controlling contact of the thermocompression-bonding head or repolishing the head contact face or changing the thermocompression-bonding head and thus to lower the running cost.

Moreover, the present invention can simplify working processes to lower the processing cost.

Thus, the present invention can provide a thermocompression-bonding apparatus, which achieves a high yield of thermocompression bonded objects with simple maintenance.

## Claims

1. A thermocompression-bonding head for establishing interconnections between connecting terminals using an adhesive film, comprising:
a thermocompression-bonding head body made of a specific alloy, and
a pressing member provided with a ceramic layer on the contact part on the bonding side of said thermocompression-bonding head body.

2. A thermocompression-bonding head according to Claim 1 wherein the difference between the thermal expansion coefficient of the thermocompression-bonding head body and the thermal expansion coefficient of the ceramic layer is within the range of ± 30 % at a temperature of 400 °C or less.

3. A thermocompression-bonding head according to Claim 1 or 2 wherein the thickness of the ceramic layer is between 0.1 mm and 0.7 mm.

4. A thermocompression-bonding head according to any one of Claims 1 to 3 wherein the ceramic material is silicon nitride.

5. A thermocompression-bonding apparatus having a thermocompression-bonding head according to any one of Claims 1 to 4 wherein said thermocompression-bonding head is pressed against objects to be bonded at a predetermined pressure.

6. A process for preparing a thermocompression-bonding head for establishing interconnections between connecting terminals using an adhesive film, comprising steps of melting a sintered rod of a ceramic material in an oxygen-acetylene flame and spraying the molten droplets of said ceramic material accelerated by air jet stream to form a layer of said ceramic material on a contact part of a pressing member of a thermocompression-bonding head body made of a specific alloy.

7. A process according to Claim 6 further comprising a step of polishing the surface of said ceramic layer to keep the head contact face of said ceramic layer within a required flatness tolerance.
